Europäisches Patentamt

European Patent Office

Office européen des brevets

(19)

(11) Veröffentlichungsnummer: **0 236 538**
**B1**

(12) **EUROPÄISCHE PATENTSCHRIFT**

(45) Veröffentlichungstag der Patentschrift:
05.09.90

(51) Int. Cl.⁵: **G01R 17/06**

(21) Anmeldenummer: **86108495.2**

(22) Anmeldetag: **21.06.86**

(54) **Schaltungsanordnung mit einem am Eingang einpolig angeschlossenen Vierpol und einem Verstärker zur Kompensation eines Bezugspotentials.**

(30) Priorität: **10.02.86 CH 519/86**

(43) Veröffentlichungstag der Anmeldung:
**16.09.87 Patentblatt 87/38**

(45) Bekanntmachung des Hinweises auf die Patenterteilung:
**05.09.90 Patentblatt 90/36**

(84) Benannte Vertragsstaaten:
**AT BE CH DE FR GB IT LI NL SE**

(56) Entgegenhaltungen:
**DE-A- 2 307 977**
**FR-A- 2 545 222**
**GB-A- 2 098 340**
**US-A- 4 142 405**

(73) Patentinhaber: **Landis & Gyr Betriebs AG,**
**CH-6301 Zug(CH)**

(72) Erfinder: **Petr, Jan, Stolzengrabenstrasse 33,**
**CH-6317 Oberwil(CH)**

## Beschreibung

Die Erfindung bezieht sich auf eine Schaltungsanordnung, mit einem über einem Eingang an eine Signalquelle einpolig angeschlossenen Vierpol und einem Verstärker zur Kompensation eines Bezugspotentials gemäss dem Oberbegriff des Anspruchs 1.

Derartige Schaltungsanordnungen werden bei Vierpolen benutzt, bei denen ein Eingangsanschluss und ein Ausgangsanschluss nicht gleichzeitig direkt an Masse gelegt werden dürfen, da ansonsten ein Teil der Vierpolschaltung kurzgeschlossen würde. Solche Vierpole sind z.B. Brückenschaltungen, die aus mindestens vier elektrischen Bauelementen aufgebaut sind und die z.B. einer Temperaturmessung, einer Druckmessung, einer Drehmomentmessung, einer Spannungsmessung, einer Magnetfeldmessung oder der Messung einer anderen physikalischen Grösse dienen. Der Vierpol kann auch irgend ein physikalisches Bauelement mit elektrischen Eingangs- und Ausgangsgrössen sein, dessen Ersatzschaltbild eine derartige Brückenschaltung ist. Ein Hallelement ist z.B. ein solches physikalisches Bauelement.

Eine Schaltungsanordnung der eingangs genannten Art ist aus der US-PS 4, 142, 405 bekannt.

Der Erfindung liegt die Aufgabe zugrunde, eine Schaltungsanordnung der eingangs genannten Art zu schaffen, bei der die Polarität des von einem Eingangssignal abhängigen Nutzanteils des Ausgangssignals des Vierpols umgeschaltet werden kann, ohne dass dabei auch gleichzeitig die Polarität des im Vierpol intern erzeugten Störanteils umgepolt wird. Diese Umschaltung der Polarität kann z.B. dazu benutzt werden, den im Vierpol erzeugten polaritätsunabhängigen Störanteil und einen in der dem Vierpol nachgeschalteten Verarbeitungselektronik erzeugten weiteren Störanteil, z.B. eine "Offset"-Spannung, vom Nutzanteil zu trennen und ihren Einfluss auf das Endergebnis zu eliminieren. Der intern im Vierpol erzeugte Störanteil ist z.B. eine Thermospannung der Ausgangsanschlüsse beim Kontakt unterschiedlicher Metalle oder, bei wechselstromgespeisten Vierpolen, ein durch Nichtlinearitäten des Vierpols entstandener Gleichstromanteil.

Die genannte Aufgabe wird erfindungsgemäss durch die im Kennzeichen des Anspruchs 1 angegebenen Merkmale gelöst.

Ein Ausführungsbeispiel der Erfindung ist in der Zeichnung dargestellt und wird im folgenden näher beschrieben.

Es zeigen:

Fig. 1 ein Schaltbild der Schaltungsanordnung und
Fig. 2 eine Brückenschaltung

Gleiche Bezugszahlen bezeichnen in allen Figuren der Zeichnung gleiche Teile.

Die Schaltungsanordnung besteht aus einem Vierpol 1, einer Quelle 2, einem Verstärker 3 und einem steuerbaren zweipoligen Umschalter 4, der einen ersten Umschaltkontakt 4a und einen zweiten Umschaltkontakt 4b besitzt.

Die Quelle 2 ist eine beliebige, mit zwei Anschlüssen 5 und 6 versehene Signalquelle, z.B. eine Stromquelle oder Spannungsquelle, die über den ersten Umschaltkontakt 4a einpolig am Eingang des Vierpols 1 angeschlossen ist. Der erste Anschluss 5 der Quelle 2 liegt an Masse. Der Verstärker 3 ist z.B. ein Operationsverstärker. Der Umschalter 4 besteht vorzugsweise aus Halbleiterschaltern, die z.B. in CMOS-Technologie hergestellt sind. Er besitzt einen Steuereingang 7, der von einer Steuerspannung $u_S$ gesteuert ist, die aus rechteckförmigen Impulsen besteht, welche den Umschalter 4 z.B. periodisch umschalten.

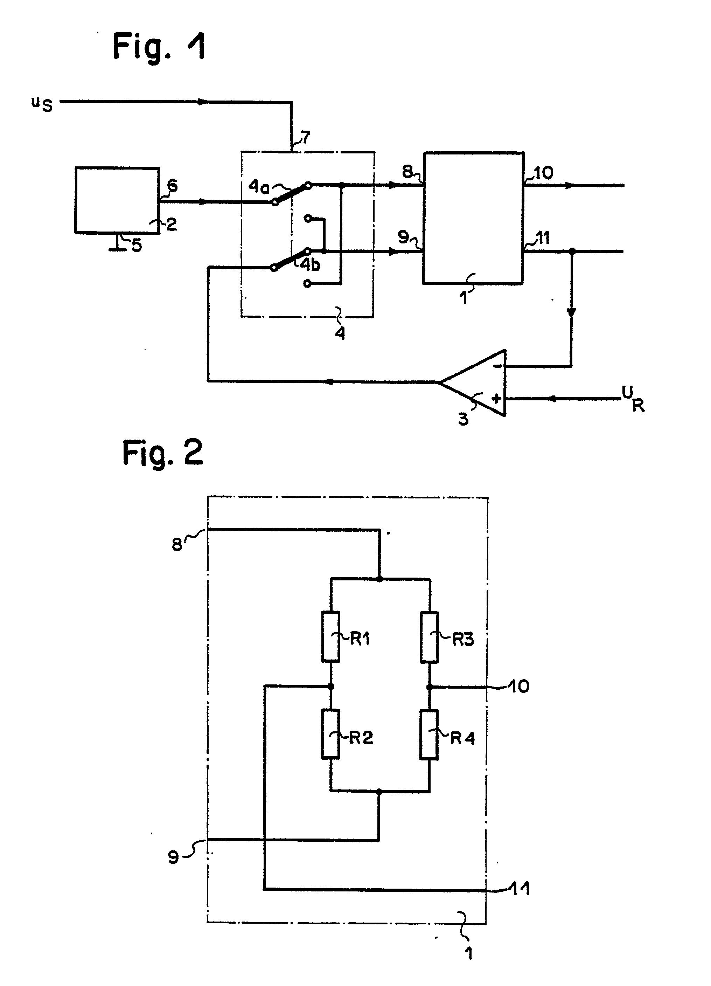

Der Vierpol 1 besitzt zwei Eingangsanschlüsse 8 und 9 sowie zwei Ausgangsanschlüsse 10 und 11. Der erste Ausgangsanschluss 10 ist der einpolige Ausgang der Schaltungsanordnung. Das am zweiten Ausgangsanschluss 11 anstehende Spannungspotential ist das Bezugspotential der Ausgangsspannung des Vierpols 1. Der das Bezugspotential führende Ausgangsanschluss 11 ist auf einen invertierenden Eingang des Verstärkers 3 geführt, dessen nichtinvertierender Eingang an einer konstanten Referenzspannung $U_R$ liegt und dessen Ausgang über den zweiten Umschaltkontakt 4b mit dem Eingangsanschluss 8 bzw. 9 des Vierpols 1 verbunden ist. Der Umschalter 4 ist an seinem Ausgang derart verdrahtet und an dem Vierpol 1, der Quelle 2 und dem Verstärker 3 derart angeschlossen, dass er in seiner ersten Stellung, d.h. in der in der Figur 1 dargestellten Position, mit seinem ersten Umschaltkontakt 4a den nicht an Masse liegenden Anschluss 6 der Quelle 2 mit dem ersten Eingangsanschluss 8 verbindet, so dass dieser Eingangsanschluss 8 einpolig an der Quelle 2 angeschlossen ist, und dass er mit seinem zweiten Umschaltkontakt 4b den Ausgang des Verstärkers 3 mit dem zweiten Eingangsanschluss 9 verbindet. In der zweiten Stellung des Umschalters 4 ist dagegen umgekehrt der Anschluss 6 der Quelle 2 über den ersten Umschaltkontakt 4a mit dem zweiten Eingangsanschluss 9 verbunden, so dass diesmal der Eingangsanschluss 9 einpolig an der Quelle 2 angeschlossen ist, und der Ausgang des Verstärkers 3 über den zweiten Umschaltkontakt 4b mit dem ersten Eingangsanschluss 8 verbunden.

Im Fall, dass der Vierpol 1 z.B. ein in einer integrierten Schaltung integriertes Hallelement ist, ist der Eingang 8; 9 des Vierpols 1 der Speiseeingang des Hallelementes und der Ausgang 10; 11 des Vierpols 1 der Ausgang des Hallelementes, an dem die Hallspannung ansteht.

Die in der Fig. 2 dargestellte Brückenschaltung besteht aus vier Widerständen R1, R2, R3 und R4 und stellt z.B. das Ersatzschaltbild eines Hallelementes dar. Die beiden Widerstände R1 und R2 sind in Reihe geschaltet, desgleichen die beiden Widerstände R3 und R4.

Die beiden Reihenschaltungen R1;R2 und R3; R4 sind dagegen parallel geschaltet. Der gemeinsame Anschluss der Widerstände R1 und R3 stellt den ersten Einganganschluss 8, der gemeinsame Anschluss der Widerstände R2 und R4 den zweiten Eingangsanschluss 9, der gemeinsame Anschluss der Widerstände R3 and R4 den ersten Ausgangsanschluss 10 und der gemeinsame Anschluss der Widerstände R1 und R2 den zweiten Ausgangsanschluss 11 jeweils des Vierpols 1 dar.

Der Verstärker 3 arbeitet als Regelverstärker, dessen Sollwert die Referenzspannung $U_R$ und dessen Istwert das Spannungspotential am zweiten Ausgangsanschluss 11 ist. Letzteres ist gleichzeitig das Bezugspotential der Ausgangsspannung des Vierpols 1 und wird mit Hilfe des Verstärkers 3 kompensiert, d.h. auf null Volt heruntergeregelt. Um dies zu erreichen, vergleicht der Verstärker 3 den Soll- und den Istwert miteinander und erzeugt an seinem Ausgang eine Spannung, die proportional der Sollwert/Istwert-Differenz ist und die über den Umschaltkontakt 4b und den Vierpol 1 dem Spannungspotential am Ausgangsanschluss 11 des Vierpols 1 derartig entgegenwirkt, dass die Sollwert/Istwert-Differenz gleich null wird. Wenn dies der Fall ist, dann ist das Spannungspotential des Ausgangsanschlusses 11 gleich der Referenzspannung $U_R$, d.h. null Volt, wenn $U_R = 0$. Wegen den vorhandenen "Offset"-Spannungen ist allerdings die Referenzspannung $U_R$ nicht genau, sondern nur annähernd gleich null Volt zu wählen.

Da das von der Quelle 2 gelieferte Nutzsignal vor Erreichen des Vierpols 1 durch den Umschaltkontakt 4a umgepolt wird, hat diese Umpolung keinen Einfluss auf die Polarität des im Vierpol 1 intern erzeugten Störanteils der Ausgangsspannung des Vierpols 1. Die Polarität dieses Störanteils ist somit unabhängig von der z.B. periodischen Polaritätsumschaltung des Nutzsignals.

## Patentansprüche

1. Schaltungsanordnung, mit einem über einen Eingang an eine Signalquelle (2) einpolig angeschlossenen Vierpol (1) und einem Verstärker (3) zur Kompensation eines Bezugspotentials, wobei ein das Bezugspotential führender Ausgangsanschluss (11) des Vierpols (1) auf einen invertierenden Eingang des Verstärkers (3) geführt ist, dessen nichtinvertierender Eingang an einer Referenzspannung ($U_R$) liegt und dessen Ausgang mit einem Eingangsanschluss (8 bzw. 9) des Vierpols (1) verbunden ist, dadurch gekennzeichnet, dass ein zweipoliger Umschalter (4) vorhanden und derart angeschlossen ist, dass in seiner ersten Stellung ein erster Eingangsanschluss (8) der einpolig angeschlossene Eingang des Vierpols (1) ist und der Ausgang des Verstärkers (3) mit einem zweiten Eingangsanschluss (9) des Vierpols (1) verbunden ist und dass in seiner zweiten Stellung umgekehrt der zweite Eingangsanschluss (9) der einpolig angeschlossene Eingang des Vierpols (1) ist und der Ausgang des Verstärkers (3) mit dem ersten Eingangsanschluss (8) des Vierpols (1) verbunden ist.

2. Schaltungsanordnung nach Anspruch 1, dadurch gekennzeichnet, dass der Vierpol (1) ein Hallelement ist.

## Claims

1. A circuit arrangement, with a four-pole device (1) connected in a single-pole manner to a signal source by way of an input and an amplifier (3) for compensation of a referal potential, wherein an output terminal (11) of the four-pole device (1), which carries the referal potential, is connected to an inverting input of the amplifier (3), the non-inverting input of which is applied to a reference voltage ($U_R$) while the output thereof is connected to an input terminal (8 or 9 respectively) of the four-pole device (1), characterised in that there is a two-pole changeover switch (4) connected in such a way that in its first position a first input terminal (8) is the input of the four-pole device (1) which is connected in a single-pole manner and the output of the amplifier (3) is connected to a second input terminal (9) of the four-pole device (1) and that conversely in its second position the second input terminal (9) is the input of the four-pole device (1), which is connected in a single-pole manner, and the output of the amplifier (3) is connected to the first input terminal (8) of the four-pole device (1).

2. A circuit arrangement according to claim 1 characterised in that the four-pole device (1) is a Hall element.

## Revendications

1. Agencement de circuit comportant un quadripôle (1) raccordé à un pôle par une entrée à une source de signaux (2), et un amplificateur (3) pour la compensation d'un potentiel de référence, un raccordement de sortie (11) du quadripôle (1), amenant le potentiel de référence, étant amené à une entrée sans inversion se trouve à une tension de référence ($U_R$) et dont la sortie est reliée à un raccordement d'entrée (8 ou 9) du quadripôle (1), caractérisé en ce qu'un commutateur bipolaire (4) est présent et raccordé de telle façon que, dans sa première position, un premier raccordement d'entrée (8) constitue l'entrée du quadripôle (1) raccordé à un pôle et que la sortie de l'amplificateur (3) est raccordée à un deuxième raccordement d'entrée (9) du quadripôle (1) et qu'à l'inverse, dans sa deuxième position de commutation, le deuxième raccord d'entrée (9) constitue l'entrée du quadripôle (1) raccordé à un pôle et la sortie de l'amplificateur (3) est reliée avec le premier raccord d'entrée (8) du quadripôle (1).

2. Agencement de circuit selon la revendication 1, caractérisé en ce que le quadripôle (1) est un élément à effet Hall.

# Fig. 1

# Fig. 2